# EUROPÄISCHE PATENTSCHRIFT

(11) **EP 4 062 183 B1**
(45) Veröffentlichungstag und Bekanntmachung des Hinweises auf die Patenterteilung: **30.09.2026**
(21) Anmeldenummer: 20812239.0
(22) Anmeldetag: 19.11.2020
(51) Int. Cl.: G01R 29/10, H04B 17/00, H04B 17/10

(54) **MESSGERÄT UND MESSVERFAHREN ZUR BESTIMMUNG EINER GESAMTEN STRAHLUNGSLEISTUNG**
MEASURING DEVICE AND MEASUREMENT METHOD FOR DETERMINING A TOTAL RADIATED POWER
APPAREIL DE MESURE ET PROCÉDÉ DE MESURE POUR DÉTERMINER UNE PUISSANCE DE RAYONNEMENT GLOBALE

(30) Priorität: 20.11.2019 DE 102019131374
(43) Veröffentlichungstag der Anmeldung: 28.09.2022
(73) Patentinhaber: Rohde & Schwarz GmbH & Co. KG, 81671 München (DE)
(72) Erfinder: BAEDER, Uwe, 85435 Erding (DE)
(74) Vertreter: Novagraaf Group
(86) Internationale Anmeldenummer: PCT/EP2020/082744
(87) Internationale Veröffentlichungsnummer: WO 2021/099498

(56) Entgegenhaltungen:
- WO-A1-2019/096802
- US-A1- 2015 331 022
- US-A1- 2019 173 593
- "5G; NR; User Equipment (UE) conformance specification; Radio transmission and reception; Part 2: Range 2 standalone (3GPP TS 38.521-2 version 15.2.0 Release 15)", vol. 3GPP RAN, no. V15.2.0, 2 May 2019 (2019-05-02), pages 1 - 223, XP014345077, Retrieved from the Internet <URL:http://www.etsi.org/deliver/etsi_ts/138500_138599/13852102/15.02.00_60/ts_13852102v150200p.pdf> [retrieved on 20190502]
- FRIDEN JONAS ET AL: "Over-the-Air Testing for Total Radiated Power of Unwanted Emissions", 2018 IEEE CONFERENCE ON ANTENNA MEASUREMENTS & APPLICATIONS (CAMA), IEEE, 3 September 2018 (2018-09-03), pages 1 - 4, XP033444183, DOI: 10.1109/CAMA.2018.8530465
- SKÖLD JOHAN: "3GPP TSG WG4 Meeting #93", 22 November 2019 (2019-11-22), CEPT.org, pages 1 - 5, XP055774527, Retrieved from the Internet <URL:https://cept.org/Documents/se-21/58453/cg-aas-se21-20-003_3gpp-ls-to-wg-se-on-cept-activities-on-5g-aas-measuremen> [retrieved on 20210210]

## Beschreibung

Die Erfindung betrifft ein Messsystem und ein Messverfahren, mit welchem eine gesamte Strahlungsleistung (total radiated power) einer Antenne einer Basisstation über die Luftschnittstelle bestimmt werden kann.

Eine Bestimmung der gesamten Strahlungsleistung einer Antenne einer Basisstation ist bislang kaum möglich, da diese nicht über kabelgebundene Anschlüsse abgegriffen werden kann. In der Druckschrift WO 2019/096802 A1 wird ein Testsystem zur Bestimmung einer gesamten Strahlungsleistung einer Antenne einer zu testenden Basisstation offenbart.

Der Erfindung liegt die Aufgabe zu Grunde, ein Testsystem und ein Testverfahren zu schaffen, welche eine Bestimmung der gesamten Strahlungsleistung einer Antenne einer Basisstation ermöglichen.

Die Aufgabe wird erfindungsgemäß für die Vorrichtung durch die Merkmale des unabhängigen Anspruchs 1 und für das Verfahren durch die Merkmale des unabhängigen Anspruchs 11 gelöst. Vorteilhafte Weiterbildungen sind Gegenstand der hierauf rückbezogenen Unteransprüche.

Ein erfindungsgemäßes Testsystem zur Bestimmung einer gesamten Strahlungsleistung einer Antenne einer zu testenden Basisstation über die Luftschnittstelle weist ein Messgerät und die zu testende Basisstation auf. Das Messgerät ist dabei ausgebildet, um eine Kommunikationsverbindung zu der zu testenden Basisstation über die Luftschnittstelle aufzubauen, und eine Funktion zum Festhalten einer gegenwärtigen Strahlform (beam-lock function) der zu testenden Basisstation über die Luftschnittstelle (over the air) zu initiieren. Das Messgerät ist weiterhin ausgebildet, mittels der Funktion zum Festhalten der gegenwärtigen Strahlform der zu testenden Basisstation, die gegenwärtige Strahlform der zu testenden Basisstation festzuhalten, und eine maximale effektive isotrope Strahlungsleistung (maximum effective isotropic radiated power) zu messen. Optional ist es ausgebildet, um die maximale effektive isotrope Strahlungsleistung vor der Messung zu identifizieren. Das Messgerät ist darüber hinaus ausgebildet, um die gesamte Strahlungsleistung der Antenne der zu testenden Basisstation aus vorbekannten Antennencharakteristika der der Antenne der zu testenden Basisstation und der gemessenen maximalen effektiven isotropen Strahlungsleistung zu bestimmen. Dadurch ist sichergestellt, dass eine genaue Bestimmung der gesamten Strahlungsleistung möglich wird.

Bevorzugt ist das Messgerät ausgebildet, ein Mobilgerät zu simulieren. Es ist dann nicht notwendig, in die Funktion der Basisstation einzugreifen.

Bevorzugt ist die zu testende Basisstation eine aktive Antennen-Basisstation (active antenna system). In diesem Fall können Funktionen des Strahlformens (beam-forming) genutzt werden, um die Hauptstrahlrichtung der Basisstation in Richtung des Messgeräts zu lenken.

Vorzugsweise nimmt ein von der zu testenden Basisstation ausgesendetes Messsignal lediglich einen Anteil eines Basisstationssignals in der Zeitdomäne und/oder in der Frequenzdomäne ein. So kann eine besonders effiziente Messung erreicht werden.

Bevorzugt ist das Testsystem ausgebildet, während des Messens der maximalen effektiven isotropen Strahlungsleistung, eine Kommunikation weiterer Mobilgeräte mit der zu testenden Basisstation zu unterbinden. So wird eine besonders interferenzfreie Messung erreicht.

Vorzugsweise ist ein Testbefehl dabei geschützt und/oder eingeschränkt. So wird sichergestellt, dass die Basisstation in einem regulären Betrieb nicht ungewollt in einen Testbetrieb geschaltet werden kann.

Vorzugsweise ist die zu testende Basisstation insbesondere ausgebildet, um lediglich nach Bestätigung durch einen Netzbetreiber auf den Testbefehl zu reagieren. So wird sichergestellt, dass ein Missbrauch des Testbetriebs nicht möglich ist.

Bevorzugt ist die zu testende Basisstation weiterhin ausgebildet, lediglich innerhalb eines vordefinierten Zeitfensters auf den Testbefehl zu reagieren. Dadurch wird die Sicherheit gegen einen ungewollten Testbetrieb weiter erhöht.

Vorzugsweise ist der Testbefehl die Funktion zum Festhalten einer gegenwärtigen Strahlform der zu testenden Basisstation und/oder ein Befehl zum Ausschluss weiterer Mobilgeräte von einer Kommunikation mit der Basisstation. So wird die Basisstation insbesondere gegen einen Missbrauch dieser Befehle geschützt.

Vorzugsweise ist die zu testende Basisstation ausgebildet, um während des Messens der maximalen effektiven isotropen Strahlungsleistung mit einer maximalen Verstärkung zu senden. So wird eine besonders genaue Messung erreicht.

Ein erfindungsgemäßes Testverfahren zur Bestimmung einer gesamten Strahlungsleistung einer Antenne einer zu testenden Basisstation, über die Luftschnittstelle, beinhaltet die folgenden Schritte:
- aufbauen einer Kommunikationsverbindung zwischen einem Messgerät und der zu testenden Basisstation über die Luftschnittstelle,
- initiieren einer Funktion zum Festhalten einer gegenwärtigen Strahlform der zu testenden Basisstation über die Luftschnittstelle durch das Messgerät,
- festhalten der gegenwärtigen Strahlform der zu testenden Basisstation, mittels der Funktion zum Festhalten der gegenwärtigen Strahlform der zu testenden Basisstation, durch das Messgerät,
- Messen einer maximalen effektiven isotropen Strahlungsleistung durch das Messgerät, und
- bestimmen der gesamten Strahlungsleistung der Antenne der zu testenden Basisstation aus vorbekannten Antennencharakteristika der Antenne der zu testenden Basisstation und der gemessenen maximalen effektiven isotropen Strahlungsleistung, durch das Messgerät.
So wird eine Bestimmung der gesamten Strahlungsleistung ermöglicht.

Nachfolgend wird die Erfindung anhand der Zeichnungen, in der ein vorteilhaftes Ausführungsbeispiel der Erfindung dargestellt ist, beispielhaft beschrieben. In den Zeichnungen zeigen:
- Fig. 1: ein erstes Ausführungsbeispiel des erfindungsgemäßen Testsystems in einer Übersichtsdarstellung;
- Fig. 2: ein zweites Ausführungsbeispiel des erfindungsgemäßen Testsystems in einer Detailansicht, und
- Fig. 3: ein Ausführungsbeispiel des erfindungsgemäßen Testverfahrens in einem Flussdiagramm.

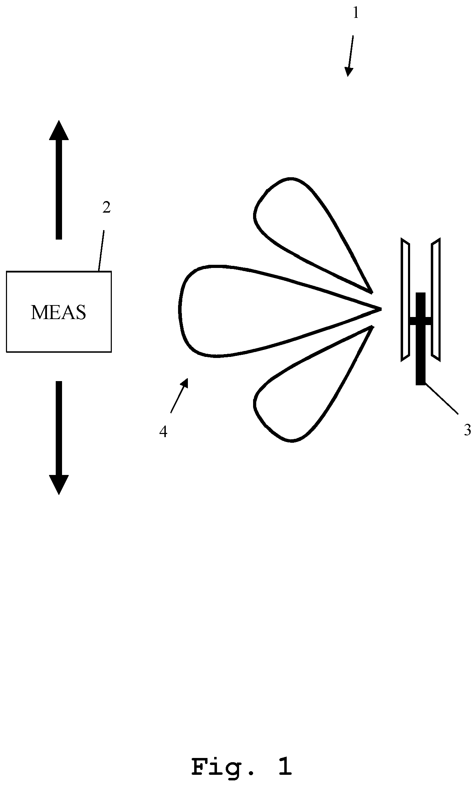

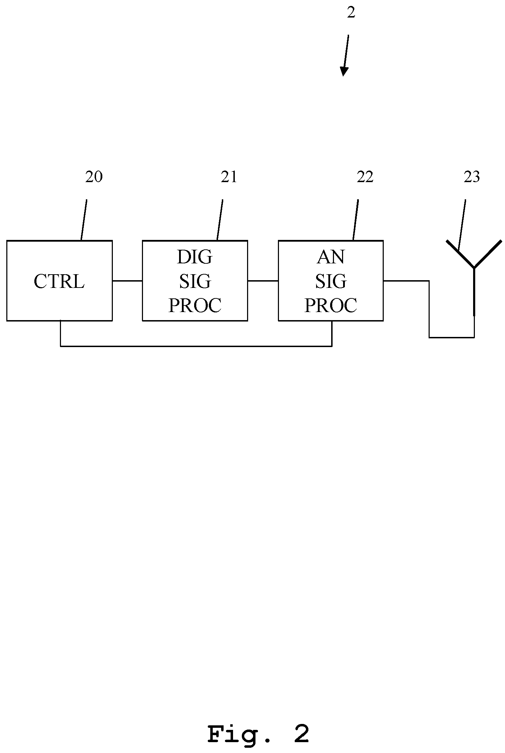

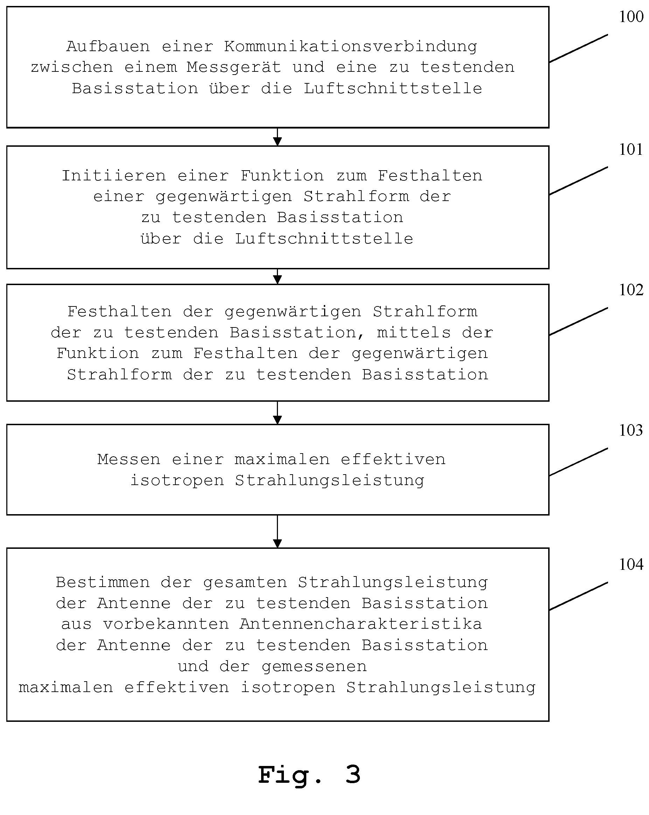

Zunächst wird anhand von Fig. 1 der allgemeine Aufbau und die allgemeine Funktion eines Ausführungsbeispiels des erfindungsgemäßen Testsystems dargestellt und erklärt. Anhand von Fig. 2 wird auf weitere Details des Aufbaus und der Funktion eines weiteren Ausführungsbeispiels des erfindungsgemäßen Testsystems eingegangen. Abschließend wird anhand von Fig. 3 auf die Funktionsweise eines Ausführungsbeispiels des erfindungsgemäßen Testverfahrens eingegangen. Identische Elemente wurden in ähnlichen Abbildungen zum Teil nicht wiederholt dargestellt und beschrieben.

In Fig. 1 ist ein erstes Ausführungsbeispiel des erfindungsgemäßen Testsystems 1 dargestellt. Das Testsystem 1 beinhaltet ein Messgerät 2 und eine zu testende Basisstation 3. Ziel des Testsystems ist es, die Aussendungen 4 der Basisstation 3 mittels des Messgeräts 2 zu vermessen.

Die von der Antenne der Basisstation 3 ausgesendeten Signale weisen eine gesamte Sendeleistung (total radiated power) auf. Diese kann jedoch im Feld nicht gemessen werden.

Um unter Realweltbedingungen die gesamte Sendeleistung zu bestimmen, wird erfindungsgemäß die maximale effektive isotrope Strahlungsleistung gemessen.

Hierzu wird zunächst eine Kommunikationsverbindung zwischen dem Messgerät 2 und der Basisstation 3 aufgebaut.

Optional wird nun die Basisstation 3 von dem Messgerät 2 dazu veranlasst, mittels Strahlformung eine Hauptstrahlrichtung der Antenne der Basisstation 3 in Richtung des Messgeräts 2 zu lenken.

Anschließend wird in einem nicht-optionalen Schritt eine Funktion zum Festhalten einer gegenwärtigen Strahlform der zu testenden Basisstation 3 durch das Messgerät 2 über die Luftschnittstelle initiiert. Mittels dieser Funktion wird anschließend die gegenwärtige Strahlform festgehalten.

Während die Strahlform festgehalten wird, erfolgt eine Messung der maximalen effektiven isotropen Strahlungsleistung (maximum effective isotropic radiated power).

Anhand einer bekannten Antennencharakteristik der Antenne der zu testenden Basisstation 3 und der gemessenen maximalen effektiven isotropen Strahlungsleistung kann anschließend auf die gesamte Strahlungsleistung der Antenne der zu testenden Basisstation 3 zurückgerechnet werden.

Falls der optionale Schritt des Lenkens der Hauptstrahlrichtung in Richtung des Messgeräts 2 nicht durchgeführt wird, so kann die Rechnung auch anhand der gemessenen effektiven Isotropenstrahlungsleistung an einer anderen Stelle der Antennencharakeristik erfolgen.

Das Messgerät 2 simuliert bei der Messung und der Kommunikation vorzugsweise ein Mobilgerät. So wird eine besonders realistische Messung ermöglicht, und gleichzeitig sind Eingriffe in die Funktion der Basisstation 3 nicht notwendig.

Um zu verhindern, dass herkömmliche mobile Geräte die im Feld eingesetzte Basisstation 3 in einen entsprechenden Testmodus versetzen, sind entsprechende Testbefehle, vorzugsweise geschützt- und/oder eingeschränkt. Insbesondere kann eine Bestätigung eines derartigen Testmodus durch den Netzbetreiber oder eine Berücksichtigung solcher Testbefehle lediglich in vorbestimmten Zeitfenstern genutzt werden.

Bevorzugt handelt es sich bei der zu testenden Basisstation 3 um eine LTE-Basisstation und/oder eine 5G Basisstation.

Um eine besonders genaue Messung zu erreichen, kann die zu testende Basisstation 3 darüber hinaus von dem Messgerät 2 dazu veranlasst werden, keine Kommunikation mit weiteren Mobilgeräten durchzuführen während die Messung durchgeführt wird. Auch ein solcher Testbefehl kann auf Seiten der Basisstation 3 geschützt oder eingeschränkt sein, um Missbrauch zu verhindern.

Um weiterhin die Genauigkeit der Messung zu erhöhen, ist die Basisstation möglichst ausgebildet, um während der Messung mit maximaler Sendeleistung bzw. maximaler Verstärkung zu senden.

Bei der Basisstation handelt es sich bevorzugt um eine aktive Antennen-Basisstation (aktiv antenna system basestation).

Um eine effiziente Messung zu erreichen, kann die Basisstation 3 das von dem Messgerät 2 gemessene Messsignal so erzeugen, dass dieses nicht das gesamte der Basisstation 3 zur Verfügung stehende Spektrum und/oder die gesamte Zeit innerhalb eines Slots ausnutzt. So ist eine besonders schnelle Messung möglich.

Eine zusätzliche Funktion des erfindungsgemäßen Testsystems ist optional die Beweglichkeit des Messgeräts 2. D.h. das Messgerät 2 ist ein mobiles Messgerät. Es kann an der Basisstation 3 vorbei bewegt werden. Erfindungsgemäß können vorzugsweise mehrere Messungen an verschiedenen Standorten im Umfeld der Basisstation 3 durchgeführt werden. An jedem dieser Standorte werden die zuvor beschriebenen Schritte dann wiederholt. So kann insbesondere neben der gesamten Strahlungsleistung auch die Funktion des Strahlformens (beam-forming) überprüft werden. Durch die Nutzung mehrerer Messungen kann darüber hinaus eine Erhöhung der Genauigkeit der Messung der gesamten Strahlungsleistung erreicht werden.

In Fig. 2 ist eine Detailansicht eines Messgeräts 2 eines weiteren Ausführungsbeispiels der gegenwärtigen Erfindung gezeigt. Das Messgerät 2 beinhaltet eine Steuereinheit 20 verbunden mit einer digitalen Signalverarbeitungseinheit 21, welche wiederum mit einer analogen Signalverarbeitungseinheit 22 verbunden ist. Diese ist mit einer Antenne 23 verbunden.

Die Steuereinheit 20 steuert dabei die digitale Signalverarbeitungseinheit 21 und die analoge Signalverarbeitungseinheit 22.

Um ein Signal an die zu testende Basisstation 3 zu senden, erzeugt die Steuereinheit 20 eine digitale Repräsentation des Signals und leitet diese an die digitale Signalverarbeitungseinheit 21 weiter. Die digitale Signalverarbeitungseinheit 21 erzeugt hieraus ein digitales Sendesignal, welches sie an die analoge Signalverarbeitungseinheit 22 weiterleitet. Diese erzeugt daraus ein analoges Hochfrequenzsendesignal, welches über die Antenne 23 ausgestrahlt wird.

Um ein Messsignal von der zu testenden Basisstation 3 zu empfangen, wird dieses von der Antenne 23 aufgefangen und an die analoge Signalverarbeitungseinheit 22 weitergeleitet. Diese erzeugt daraus ein digitales Empfangssignal und leitet dieses an die digitale Signalverarbeitungseinheit 21 weiter. Die digitale Signalverarbeitungseinheit 21 bestimmt aus dem digitalen Empfangssignal die maximale effektive isotrope Strahlungsleistung und leitet diese an die Steuereinheit 20 weiter, welche daraus die gesamte Strahlungsleistung bestimmt. Hierzu nutzt sie darüber hinaus die vorbekannte Antennencharakteristik der Antenne der zu testenden Basisstation 3.

In Fig. 3 ist ein Ausführungsbeispiel des erfindungsgemäßen Messverfahrens in einem Flussdiagramm gezeigt.

In einem ersten Schritt 100 wird eine Kommunikationsverbindung zwischen einem Messgerät und einer zu testenden Basisstation über eine Luftschnittstelle aufgebaut.

In einem zweiten Schritt 101 wird eine Funktion zum Festhalten einer gegenwärtigen Strahlform (beam-lockfunction) über die Luftschnittstelle initiiert.

In einem dritten Schritt 102 wird die gegenwärtige Strahlform der zu testenden Basisstation mittels der Funktion zum Festhalten der gegenwärtigen Strahlform der zu testenden Basisstation festgehalten.

In einem vierten Schritt 103 wird eine maximale effektive isotrope Strahlungsleistung gemessen.

In einem fünften Schritt 104 wird die gesamte Strahlungsleistung der Antenne der zu testenden Basisstation aus einer vorbekannten Antennencharakteristik der Antenne der zu testenden Basisstation und der gemessenen maximalen effektiven isotropen Strahlungsleistung bestimmt.

Die Erfindung wird durch die beigefügten Ansprüche definiert.

## Patentansprüche

1. Testsystem (1) zur Bestimmung einer gesamten Strahlungsleistung einer Antenne einer zu testenden Basisstation (3), über die Luftschnittstelle, aufweisend:
- ein Messgerät (2),
- die zu testende Basisstation (3),
wobei das Messgerät (2) ausgebildet ist, um
- eine Kommunikationsverbindung zu der zu testenden Basisstation (3) über die Luftschnittstelle aufzubauen,
- eine Funktion zum Festhalten einer gegenwärtigen Strahlform (4) der zu testenden Basisstation (3) über die Luftschnittstelle zu initiieren,
- mittels der Funktion zum Festhalten der gegenwärtigen Strahlform (4) der zu testenden Basisstation (3), die gegenwärtige Strahlform der zu testenden Basisstation (3) festzuhalten,
**dadurch gekennzeichnet**
- eine maximale effektive isotrope Strahlungsleistung zu messen, und
- die gesamte Strahlungsleistung der Antenne der zu testenden Basisstation (3) aus vorbekannten Antennencharakteristika der Antenne der zu testenden Basisstation (3) und der gemessenen maximalen effektiven isotropen Strahlungsleistung zu bestimmen.

2. Testsystem (1) nach Anspruch 1,
wobei das Messgerät (2) ausgebildet ist, ein Mobilgerät zu simulieren.

3. Testsystem (1) nach Anspruch 1 oder 2,
wobei die zu testende Basisstation (3) eine aktive Antennen-Basisstation (3) ist.

4. Testsystem (1) nach einem der Ansprüche 1 bis 3,
wobei ein von der zu testenden Basisstation (3) ausgesendetes Messsignal lediglich einen Anteil eines Basisstationssignals in der Zeitdomäne und/oder in der Frequenzdomäne ausfüllt.

5. Testsystem (1) nach einem der Ansprüche 1 bis 4,
wobei das Testsystem (1) ausgebildet ist, während des Messens der maximalen effektiven isotropen Strahlungsleistung, eine Kommunikation weiterer Mobilgeräte mit der zu testenden Basisstation (3) zu unterbinden.

6. Testsystem (1) nach einem der Ansprüche 1 bis 5,
wobei ein Testbefehl geschützt und/oder eingeschränkt ist.

7. Testsystem (1) nach Anspruch 6,
wobei die zu testende Basisstation (3) ausgebildet ist, lediglich nach Bestätigung durch einen Netzbetreiber auf den Testbefehl zu reagieren.

8. Testsystem (1) nach Anspruch 6 oder 7,
wobei die zu testende Basisstation (3) ausgebildet ist, lediglich innerhalb eines vordefinierten Zeitfensters auf den Testbefehl zu reagieren.

9. Testsystem (1) nach einem der Ansprüche 6 bis 8,
wobei der Testbefehl die Funktion zum Festhalten einer gegenwärtigen Strahlform (4) der zu testenden Basisstation (3) ist, und/oder ein Befehl zum Ausschluss weiterer Mobilgeräte von einer Kommunikation mit der Basisstation (3) .

10. Testsystem (1) nach einem der Ansprüche 1 bis 9, wobei die zu testende Basisstation (3) ausgebildet ist, während des Messens der maximalen effektiven isotropen Strahlungsleistung, mit einer maximalen Verstärkung zu senden.

11. Testverfahren zur Bestimmung einer gesamten Strahlungsleistung einer Antenne einer zu testenden Basisstation (3), über die Luftschnittstelle, mit den folgenden Schritten:
- aufbauen (100) einer Kommunikationsverbindung zwischen einem Messgerät (2) und der zu testenden Basisstation (3) über die Luftschnittstelle,
- initiieren (101) einer Funktion zum Festhalten einer gegenwärtigen Strahlform (4) der zu testenden Basisstation (3) über die Luftschnittstelle durch das Messgerät (2),
- festhalten (102) der gegenwärtigen Strahlform (4) der zu testenden Basisstation (3), mittels der Funktion zum Festhalten der gegenwärtigen Strahlform (4) der zu testenden Basisstation (3), durch das Messgerät (2),
**gekennzeichnet durch**
- messen (103) einer maximalen effektiven isotropen Strahlungsleistung durch das Messgerät (2), und
- bestimmen (104) der gesamten Strahlungsleistung der Antenne der zu testenden Basisstation (3) aus vorbekannten Antennencharakteristika der Antenne der zu testenden Basisstation (3) und der gemessenen maximalen effektiven isotropen Strahlungsleistung, durch das Messgerät (2).

## Claims

1. Test system (1) for determining, over the air, a total radiated power of an antenna of a base station (3) to be tested, which test system comprises:
- a measuring device (2),
- the base station to be tested (3),
the measuring device (2) being designed
- to establish, over the air, a communication link to the base station (3) to be tested,
- to initiate, over the air, a function for locking a current beam form (4) of the base station (3) to be tested,
- to lock the current beam form of the base station (3) to be tested, by means of the function for locking the current beam form (4) of the base station (3) to be tested,
**characterized by**
- measuring a maximum effective isotropic radiated power, and
- determining, from previously known antenna characteristics of the antenna of the base station (3) to be tested and from the measured maximum effective isotropic radiated power, the total radiated power of the antenna of the base station (3) to be tested.

2. Test system (1) according to claim 1,
the measuring device (2) being designed to simulate a mobile device.

3. Test system (1) according to claim 1 or 2,
the base station (3) to be tested being an active antenna base station (3).

4. Test system (1) according to any of claims 1 to 3,
a measuring signal emitted by the base station (3) to be tested only filling a portion of a base station signal in the time domain and/or in the frequency domain.

5. Test system (1) according to any of claims 1 to 4,
the test system (1) being designed to prevent communication of further mobile devices with the base station (3) to be tested during the measuring of the maximum effective isotropic radiated power.

6. Test system (1) according to any of claims 1 to 5,
a test command being protected and/or restricted.

7. Test system (1) according to claim 6,
the base station (3) to be tested being designed to only respond to the test command after confirmation by a network operator.

8. Test system (1) according to claim 6 or 7,
the base station (3) to be tested being designed to only respond to the test command within a predefined time window.

9. Test system (1) according to any of claims 6 to 8,
the test command being the function for locking a current beam form (4) of the base station (3) to be tested, and/or a command to exclude further mobile devices from communicating with the base station (3).

10. Test system (1) according to any of claims 1 to 9, the base station (3) to be tested being designed to transmit at a maximum gain during the measuring of the maximum effective isotropic radiated power.

11. Test method for determining, over the air, a total radiated power of an antenna of a base station (3) to be tested, the method comprising the following steps:
- establishing (100), over the air, a communication link between a measuring device (2) and the base station (3) to be tested,
- initiating (101), over the air, a function for locking a current beam form (4) of the base station (3) to be tested, by the measuring device (2),
- locking (102), by the measuring device (2), the current beam form (4) of the base station (3) to be tested, by means of the function for locking the current beam form (4) of the base station (3) to be tested,
**characterized by**
- measuring (103), by the measuring device (2), a maximum effective isotropic radiated power and
- determining (104), by the measuring device (2), the total radiated power of the antenna of the base station (3) to be tested from previously known antenna characteristics of the antenna of the base station (3) to be tested and from the measured maximum effective isotropic radiated power.

## Revendications

1. Système de test (1) permettant de déterminer une puissance rayonnante totale d'une antenne d'une station de base à tester (3), par l'intermédiaire de l'interface sans fil, présentant :
- un appareil de mesure (2),
- la station de base à tester (3),
dans lequel l'appareil de mesure (2) est configuré pour
- établir une connexion de communication avec la station de base à tester (3) par l'intermédiaire de l'interface sans fil,
- initier une fonction permettant de capturer une forme de faisceau actuelle (4) de la station de base à tester (3) par l'intermédiaire de l'interface sans fil,
- capturer la forme de faisceau actuelle de la station de base à tester (3) au moyen de la fonction permettant de capturer la forme de faisceau actuelle (4) de la station de base à tester (3),
**caractérisé par**
- la mesure d'une puissance isotrope apparente rayonnée maximale, et
- la détermination de la puissance rayonnante totale de l'antenne de la station de base à tester (3) à partir de caractéristiques d'antenne connues au préalable de l'antenne de la station de base à tester (3) et de la puissance isotrope apparente rayonnée maximale mesurée.

2. Système de test (1) selon la revendication 1,
dans lequel l'appareil de mesure (2) est configuré pour simuler un appareil mobile.

3. Système de test (1) selon la revendication 1 ou 2,
dans lequel la station de base à tester (3) est une station de base à antenne active (3).

4. Système de test (1) selon l'une des revendications 1 à 3,
dans lequel un signal de mesure émis par la station de base à tester (3) ne complète qu'une partie d'un signal de station de base dans le domaine temporel et/ou dans le domaine fréquentiel.

5. Système de test (1) selon l'une des revendications 1 à 4,
dans lequel le système de test (1) est configuré pour empêcher, pendant la mesure de la puissance isotrope apparente rayonnée maximale, toute communication d'autres appareils mobiles avec la station de base à tester (3).

6. Système de test (1) selon l'une des revendications 1 à 5,
dans lequel une instruction de test est protégée et/ou restreinte.

7. Système de test (1) selon la revendication 6,
dans lequel la station de base à tester (3) est configurée pour ne réagir à l'instruction de test qu'après un actionnement par une entité exploitante.

8. Système de test (1) selon la revendication 6 ou 7,
dans lequel la station de base à tester (3) est configurée pour ne réagir à l'instruction de test que dans une fenêtre temporelle prédéfinie.

9. Système de test (1) selon l'une des revendications 6 à 8,
dans lequel l'instruction de test est la fonction permettant de capturer une forme de faisceau actuelle (4) de la station de base à tester (3), et/ou une instruction pour l'exclusion d'autres appareils mobiles de toute communication avec la station de base (3).

10. Système de test (1) selon l'une des revendications 1 à 9, dans lequel la station de base à tester (3) est configurée pour émettre avec un gain maximal pendant la mesure de la puissance isotrope apparente rayonnée maximale.

11. Procédé de test permettant de déterminer une puissance rayonnante totale d'une antenne d'une station de base à tester (3), par l'intermédiaire de l'interface sans fil, comportant les étapes suivantes :
- fait d'établir (100) une connexion de communication entre un appareil de mesure (2) et la station de base à tester (3) par l'intermédiaire de l'interface sans fil,
- fait d'initier (101), par l'appareil de mesure (2), une fonction permettant de capturer une forme de faisceau actuelle (4) de la station de base à tester (3) par l'intermédiaire de l'interface sans fil,
- fait de capturer (102), par l'appareil de mesure (2), la forme de faisceau actuelle (4) de la station de base à tester (3) au moyen de la fonction permettant de capturer la forme de faisceau actuelle (4) de la station de base à tester (3), **caractérisé par**
- la mesure (103), par l'appareil de mesure (2), d'une puissance isotrope apparente rayonnée maximale, et
- la détermination (104), par l'appareil de mesure (2), de la puissance rayonnante totale de l'antenne de la station de base à tester (3) à partir de caractéristiques d'antenne connues au préalable de l'antenne de la station de base à tester (3) et de la puissance isotrope apparente rayonnée maximale mesurée.
